# EUROPEAN PATENT APPLICATION

(11) **EP 2 315 252 A2**
(43) Date of publication of application: **27.04.2011**
(21) Application number: 10188468.2
(22) Date of filing: 22.10.2010
(51) Int. Cl.: H01L 27/32, H01L 51/56

(54) **Organic electronic devices and methods for manufacturing the same**

(30) Priority: 22.10.2009 US 272694 P
(71) Applicant: CSEM Centre Suisse d'Electronique et de Microtechnique SA - Recherche et Développement, 2002 Neuchâtel (CH)
(72) Inventor: Beierlein, Tilman, 8800 Thalwil (CH)
(74) Representative: Schneider Feldmann AG Patent- und Markenanwälte

(57) **Abstract**

The present invention discloses a method for manufacturing an Organic-Electronic (OE) Device. The method comprises providing at least one lower electrode onto a substrate; providing at least one lower organic layer onto the lower electrode; providing at least one upper electrode onto the lower organic layer to obtain an OE stack; providing a glue, providing a cover, and dicing the OE stack into a plurality of OE dies, and providing a plurality of side-contact electrodes on at least one sidewall of the OE dies. A plurality of voltages is respectively applicable to the plurality of side-contacted electrodes such that the plurality of side-contacted electrodes become electrically connected over the at least one organic layer.

## Description

### CROSS-REFERENCE TO RELATED APPLICATIONS

This Patent Application claims priority from US Provisional Application 61/272,694 filed on October 22, 2009, the disclosure of which is incorporated herein by reference in its entirety.

### FIELD OF THE INVENTION

The present invention relates to organic electronic devices (OEDs) in general and in particular to organic light-emitting devices (OLEDs), organic field-effect transistors (OFETs), organic memory devices (OMEM) and organic photovoltaic devices (OPVDs).

### DESCRIPTION OF THE FIGURES

These and further features and advantages of the invention will become more clearly understood in the light of the ensuing description of the embodiments thereof, given by way of example only, with reference to the accompanying figures, wherein:

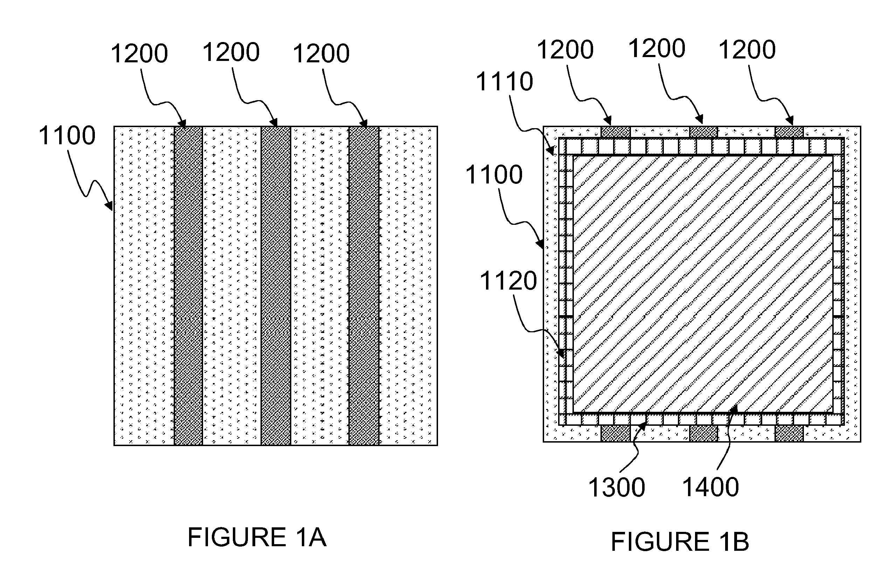

**FIGURE 1A** is a schematic top view illustration of an OE stack comprising a substrate with the patterned lower electrode material provided thereon, according to an embodiment of the invention;

**FIGURE 1** **B** is a schematic top view illustration of the stack of **FIGURE 1A** further with a lower and an upper organic layer provided thereon, according to an embodiment of the invention;

**FIGURE 2A** is a schematic top view illustration of the OE stack of **FIGURE** 1 **B,** further with the patterned upper electrode material provided thereon, according to an embodiment of the invention;

**FIGURE 3** is a schematic top view illustration of the OE stack of **FIGURE 2A****,** further comprising a cover provided on the OE stack, according to an embodiment of the invention;

**FIGURE 4A** is a schematic cross-sectional side view illustration of the stack of **FIGURE 3** in a first orientation, according to an embodiment of the invention;

**FIGURE 4B** is a schematic cross-sectional side view illustration of the OE stack of **FIGURE 3** in a second orientation rotated by 90 degrees with respect to the above-mentioned first orientation, according to an embodiment of the invention;

**FIGURE 5** is a schematic cross-sectional side view illustration of an OE stack separated into an upper stack part and a lower stack part, the OE stack comprising at least one patterned sacrificial layer, according to an embodiment of the invention;

**FIGURE 6** is a schematic cross-sectional side view illustration of the OE stack of **FIGURE 5****,** wherein the upper stack and lower stack part are merged, and wherein cutting lines are schematically indicated, according to an embodiment of the invention;

**FIGURE 7A** is a schematic cross-sectional side view illustration of an OE die comprising the sacrificial layers, according to an embodiment of the invention;

**FIGURE 7B** is a schematic cross-sectional side view illustration of an OE die, the sacrificial layers being removed therefrom according to an embodiment of the invention;

**FIGURE 7C** is a schematic cross-sectional side view illustration of an Organic Electronic Device (OED) including a first and a second side-contact electrode;

**FIGURE 8A** is a schematic cross-sectional side view illustration of an OE assembly, according to an embodiment of the invention;

**FIGURE 8B** is a schematic cross-sectional side view illustration of an OE assembly, according to an alternative embodiment of the invention;

**FIGURE 9A** is a schematic cross-sectional side view illustration of an OE assembly, according to another embodiment of the invention; and

**FIGURE 9B** is a schematic cross-sectional side view illustration of an OE assembly, according to a yet other embodiment of the invention.

It will be appreciated that for simplicity and clarity of illustration, elements shown in the figures have not necessarily been drawn to scale. For example, the dimensions of some of the elements may be exaggerated relative to other elements for clarity. Further, where considered appropriate, reference numerals and/or letters may be repeated among the figures to indicate identical or analogous elements but may not be referenced in the description for all figures.

### BACKGROUND OF THE INVENTION

Inorganic light-emitting diodes are light-emitting elements employed for small indicators and tiny signal lamps. Such inorganic light-emitting diodes are based on inorganic semiconductor materials such as Galliumarsenide (GaAs), Galliumphosphide (GaP), Galliumnitride (GaN), Indiumgalliumnitride (InGaN). These inorganic semiconductor materials are grown on crystalline substrates at high temperature. The resulting stack are then diced into pieces having edge sizes in the order of 100 µm, bonded to a conducting substrate constituting a lower electrode, and connected via wire-bond to a second electrode. In order to increase the emissive area of the die obtained thereby, diffusers and optics need to be added.

Compared to inorganic light emitting diodes, organic electric devices (OEDs) like organic light-emitting diodes (OLEDs) may provide larger emitting areas. OLED elements for displays and lighting elements are fabricated on glass substrates or polymeric substrates with a lateral dimension typically ranging from 25 mm to several hundreds of millimeters. In order to encapsulate the OLED elements, the substrate for the OLED elements and/or the cover glass is framed with adhesive. After providing the adhesive, the substrate and cover glass are merged together to obtain encapsulated OLED elements and are then diced to obtain individual encapsulated dices comprising a respective OLED element. In order to be able to provide electrical contacts on the substrate's surface, the OLED dices have a glass cover of smaller planar dimension than the corresponding substrate.

The following documents specify OLED structures and manufacturing processes.

US patent 5'962'962 discloses a method of encapsulation for an organic electroluminescent (EL) device, which includes an inert liquid layer having a dissolved oxygen concentration of 1 ppm or less on the periphery of the organic EL device. More specifically, the disclosed electrode layers, i.e. anode and cathode, are structured to extend through the frame of the adhesive for contact outside the encapsulation glass which is smaller than the substrate.

US patent 5'057'967 document discloses a rolled film capacitor comprising a pair of dielectric film strips piled one upon another and wound into a roll, each strip having a metal electrode pattern deposited on one surface thereof, the pattern including a number of rectangular island electrodes mutually separated by a plurality of lateral and longitudinal insulating gaps and regularly arrayed in both directions, the island electrodes mutually overlapping to form a number of small capacitor elements which are connected in series in both directions by shifting both strips one from another in both directions. A plurality of such capacitors can be aggregated to form an improved large capacitive power supply device.

Other OEDs such as organic field-effect transistors (OFETs) and organic photovoltaic devices (OPVDs) are encapsulated and electrically contacted in a way similar to OLEDs. Generally, the area needed to establish electrical contacts is rather large, typically on the order of 1-5 mm².

### DESCRIPTION OF THE INVENTION

It should be noted that the term "sidewall" as used herein refers to an OED surface or surfaces extending in the direction according to which layers of material of the OED are provided. In other words, the term "sidewall" refers to the surface defining the boundary of the planar expanse of a plurality of material layers forming the OED.

The terms "right", "left", "bottom", "below", "lower", "top", "above", "elevated" and "upper" as well as grammatical variations thereof as used herein do not necessarily indicate that, for example, a "bottom" component is below a "top" component, or that a component that is "below" is indeed "below" another component or that a component that is "above" is indeed "above" another component as such directions, components or both may be flipped, rotated, moved in space, placed in a diagonal orientation or position, placed horizontally or vertically, or similarly modified. Accordingly, it will be appreciated that the terms "bottom", "below", "top" and "above" may be used herein for exemplary purposes only, to illustrate the relative positioning or placement of certain components, to indicate a first and a second component or to do both.

It should be noted that in respective embodiments of the invention, the term "determining" as used herein may refer to methods whose output may be an estimate of a parameter.

Summary of the invention

The present invention discloses a method for manufacturing an Organic-Electronic Device (OED). The method comprises providing at least one lower electrode onto a substrate; providing at least one lower organic layer onto the lower electrode; providing at least one upper electrode onto the lower organic layer to obtain an OE stack; and dicing the OE stack into a plurality of OE dies.

In embodiments of the invention, the method comprises providing a plurality of side-contact electrodes, to at least one sidewall of an OE die. The plurality of side-contact electrodes are electrically disconnected from another such that said plurality of side-contact electrodes can be subjected to a prevailing voltage difference therebetween between.

In some embodiments of the invention, the method comprises providing a plurality of side-contact electrodes to a plurality of sidewalls of an OE die, respectively.

In embodiments of the invention, the method comprises providing a first and a second side-contact electrode respectively on at least one sidewall of at least one of the plurality of OE dies. Accordingly, the same sidewall may comprise a plurality of side-contact electrodes.

In some embodiments, the method comprises providing a first and a second side-contact electrode respectively on the first and second sidewall.

In embodiments of the invention, the first side-contact electrode is electrically coupled with the first lower electrode.

In embodiments of the invention, the second side-contact electrode is electrically coupled with the second lower electrode.

In embodiments of the invention, a first and a second voltage is respectively applicable to the first and the second side-contact electrode such that the lower and upper electrode become electrically connected over the at least one lower organic layer.

In embodiments of the invention, the method comprises providing a glue onto the upper electrode.

In embodiments of the invention, the method comprises providing a cover onto the upper electrode to obtain an OE stack.

In embodiments of the invention, the method comprises providing a sacrificial layer prior to dicing the OE stack.

In embodiments of the invention, the method comprises removing the sacrificial layer after dicing the OE stack into OE dies to obtain indentations.

In embodiments of the invention, the indentations increase the area of the sidewalls of the OE dies.

In embodiments of the invention, the method comprises providing the lower and the upper electrodes on the sidewalls with the increased contact area.

In embodiments of the invention, the method comprises providing the lower and the upper electrodes such that they engage and/or fill the indentations.

In embodiments of the invention, the method comprises providing a getter material onto the upper electrode material.

In embodiments of the invention, the method comprises the getter material absorbs impurities such as, for example, oxygen and/or moisture, to avoid degradation.

The present invention further disclose an Electronic Device (OED) comprising: a substrate; at least one lower electrode on the substrate; at least one organic layer, wherein the at least one lower electrode is embedded between the substrate and the at least one organic layer; and at least one upper electrode provided on the lower organic layer.

In embodiments of the invention, the OED comprises a first side-contact electrode; and a second side-contact electrode. The side-contact electrodes may be provided on at least one sidewall of the OED.

In embodiments of the invention, the first side-contact electrode and the second side-contact electrodes are provided on a first and a second sidewall of the OED.

In embodiments of the invention, the first and the second sidewall of the OED have one of the following orientations with respect to each other: the first sidewall is opposite to the second sidewall, or the first sidewall is adjacent and to the second sidewall and form an angle of at least approximately 90 degrees.

In embodiments of the invention, the side-contact electrodes are provided by employing vacuum deposition of metal or solution deposition of conductive ink and/or conductive paste.

In embodiments of the invention, the plurality of side-contact electrodes have a thickness that is ≤ 1 µm.

In embodiments of the invention, the OED may be embodied by at least one of the following devices: Organic light-emitting diode, an organic field-effect transistor, and an organic photovoltaic device.

In embodiments of the invention, the electrical contact area between the plurality of side-contact electrodes and the lower electrode material, as well as the electrical contact area between the plurality of side-contact electrodes and the upper electrode material, is the cross sectional area of the strips of the lower and upper electrode material.

The present invention further discloses an Organic Electronic (OE) Assembly comprising an OED according to an embodiment of the invention, wherein said OED is electrically coupled with a printed circuit board.

Detailed Description of the Invention

It is an objective of the underlying invention to teach alternative Organic Electric Devices (OEDs) that have an increased ratio between the coverage area of the active area and the total coverage area of the organic device (active-to-total area ratio), as well as methods of manufacturing such OEDs. More specifically, OEDs according to an embodiment of the invention comprise electrical side contacts. An OED may include, for example, an Organic Light-Emitting Diode (OLED), an Organic Field-Effect Transistor (OFET), an Organic Photovoltaic Device (OPVD), or any combination of the aforesaid. In embodiments of the invention, the OED may be may used for at least one of the following applications: a light source, a self-emitting indicators, pictograms, excitation sources for sensor applications.

A plurality of OEDs having increased active-to-total area ratio may be manufactured by employing wafer scale processes.

The employment of wafer scale processes includes the production of an OE stack which is then diced according to a predetermined dicing pattern into a plurality of OE dies. The employment of wafer scale processes for example enables the manufacturing of OE dies having lateral dimensions (in the x-y plane) of, for example, 50 x 50 mm², ≤10 x 10mm².

According to an embodiment of the invention, the method of manufacturing an OED includes providing an OE die with electrical connections, which are embodied by electrically conductive materials. Methods of providing the OE die with electrically conductive material include (hereinafter: electrode layer), for example, at least one of the following processes: the evaporation of metal, spraying conductive ink, and spraying conductive paste. According to an embodiment of the invention, the electrically conductive material is provided on at least one sidewall of the OE die to make electrical contact with a lower and an upper electrode layer in a manner such that a voltage difference prevails between the lower and the upper electrode layer. As a result, the planar dimensions of the OE die and of the resulting OED are almost equal, wherein their difference in planar dimensions is defined by the thickness t_{electr} of the electrode layer provided. More specifically, if the planar dimensions of an OE die is defined by the mathematical term L_{dice} x W_{dice}, then the planar dimensions of the corresponding OED may be described by the mathematical term (L_{dice} + t_{electr}) x W_{dice} or (L_{dice} + 2 x t_{electr}) x W_{dice}, for an OED with one or two electrode layers, respectively.

**TABLE 1 below exemplifies ranges of measures of electrode layers:**

| | **First Option of Ranges** | **Second Option of Ranges** | **Third Option of Ranges** |
|---|---|---|---|
| **Thickness of Electrode Layers** | 3 nm- 10 µm | 10 nm - 1 µm | 10 nm - 200 nm |
| **Width of Electrode Layers** | 0.5 µm - 20 mm | 5 µm - 10 mm | 50 µm - 5 mm |

According to an embodiment of the invention, an OED with increased active-to-total area ratio may be manufactured individually according to an embodiment of the invention.

Reference is now made to **FIGURE 1A****.** The method for manufacturing an OED like, e.g., an OLED, may include the procedure of providing a substrate **1100** with a lower electrode material, e.g., by coating. For example, a lower electrode material **1200** may be provided in the form of a plurality of stripes. The plurality of lower stripes of lower electrode material **1200** may be provided such to extend over the entire surface of substrate **1100** and in a patterned manner to be arranged at least approximately in parallel with respect to each other. The plurality of lower stripes of lower electrode material **1200** may be equidistantly arranged with respect to each other.

Further reference is now made to **FIGURE 1** **B.** According to an embodiment of the invention, at least one organic layer is then provided, e.g., by deposition on top of the first plurality of strips of the electrode material and the substrate. The at least one organic layer may for example be embodied by a layer of light emitting cells (LECs). For example, a lower organic layer **1300** and an upper organic layer **1400** are then provided, e.g., by deposition, on top of the plurality of strips of lower electrode material **1200** and substrate **1100.** In embodiment of the invention, the lower organic layer **1300** and upper organic layer **1400** may be provided such to cover substrate **1100** and first stripes of lower electrode material **1200** entirely. Alternatively, lower organic layer **1300** and upper organic layer **1400** may be provided such to cover substrate **1100** and first strips of electrode layer partially leaving out a first rim **1110** along the edge of substrate **1100.** In some embodiments, circumferential first rim **1110** and/or a second rim **1120** may be of uniform width on all sides of substrate **1100.** Alternatively, opposite sides of first rim **1110** and/or second rim **1120** may have different widths.

In some embodiments, the length and width of upper organic layer **1400** may be shorter than the length and width of lower organic layer **1300,** therefore partially leaving out a second rim **1120** between lower organic layer **1300** and upper organic layer **1400.**

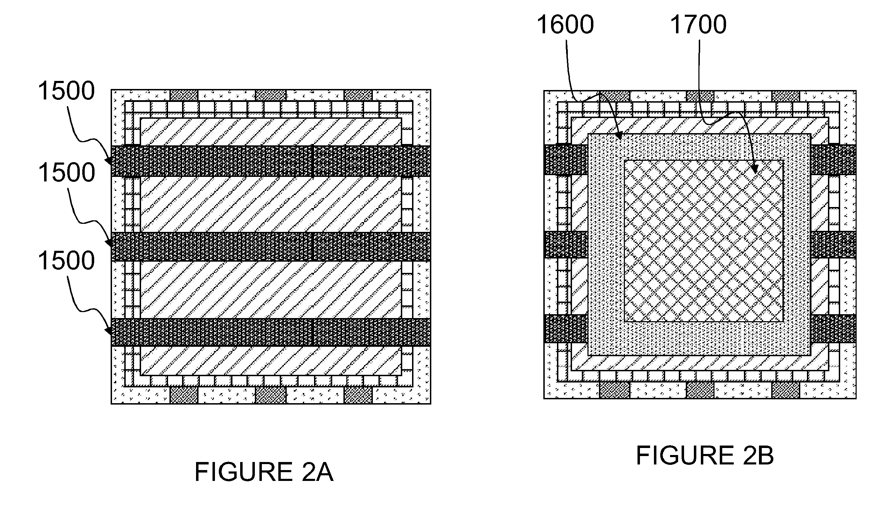

Additional reference is now made to **FIGURE 2A****.** The method of manufacturing an OED according to an embodiment of the invention may then include the step of providing (e.g., by deposition) an upper electrode material on top of the at least one organic layer. For example, upper electrode material **1500** may be provided in a patterned manner onto upper organic layer **1400.** In an embodiment of the invention, upper electrode material **1500** may be provided to form a plurality of at least approximately parallel stripes, which may be equidistantly arranged with respect to each other. Moreover, the plurality of strips of upper electrode material **1500** may be rotated by an angle of at least approximately θ=90°. Otherwise stated, the plurality of parallel strips of upper electrode material **1500** may be perpendicularly oriented with respect to the plurality of strips of lower electrode material **1200.** Upper electrode material **1500** may be provided to be in symmetry with the boundaries of substrate **1100.**

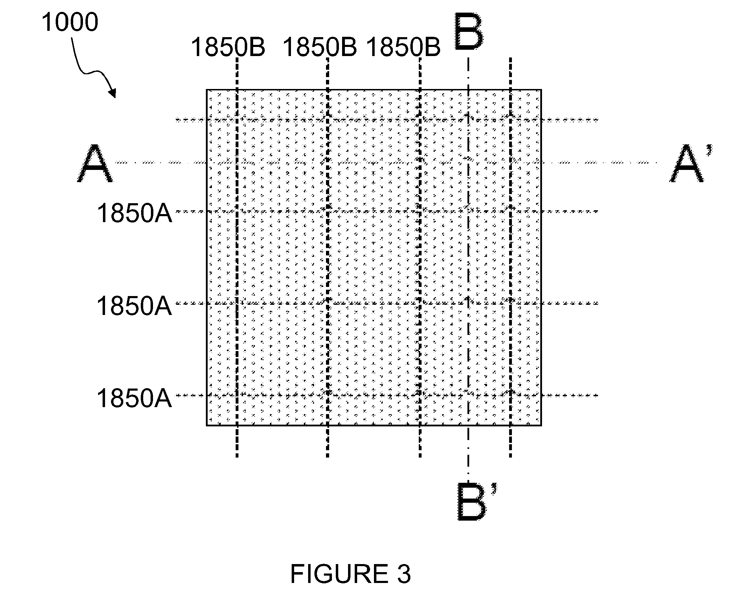

Additional reference is now made to **FIGURE 2B** and **3****.** The method of manufacturing an OED device may include in some embodiments of the invention the step of providing a getter material **1600 (****FIGURE 2B****)** onto upper organic layer **1400,** and upper electrode material **1500.** Getter material **1600** may be provided in a manner to cover upper organic layer **1400** (and therefore upper electrode material **1500)** only partially, and optionally in a manner to be in symmetry with the boundaries of substrate **1100**. Further, glue **1700** may then be dispensed **(****FIGURE 2B****)** to glue or laminate thereon a cover **1800 (****FIGURE 3****)** for protection of the elements of OED **1001** between substrate **1100** and cover **1800,** for example, from moisture. Cover **1800** may be provided such to cover the entirety of the lateral dimensions of substrate **1100** to finalize an OE stack **1000.**
After hardening of glue **1700,** OE stack **1000** is then cut along horizontal and vertical cutting lines **1850A and 1850B** into OE dies having dimensions of, for example, 7x7 mm. The method of cutting may be realized, for example, by employing at least one of the following techniques: scribe-and-break; sawing; and laser cutting.

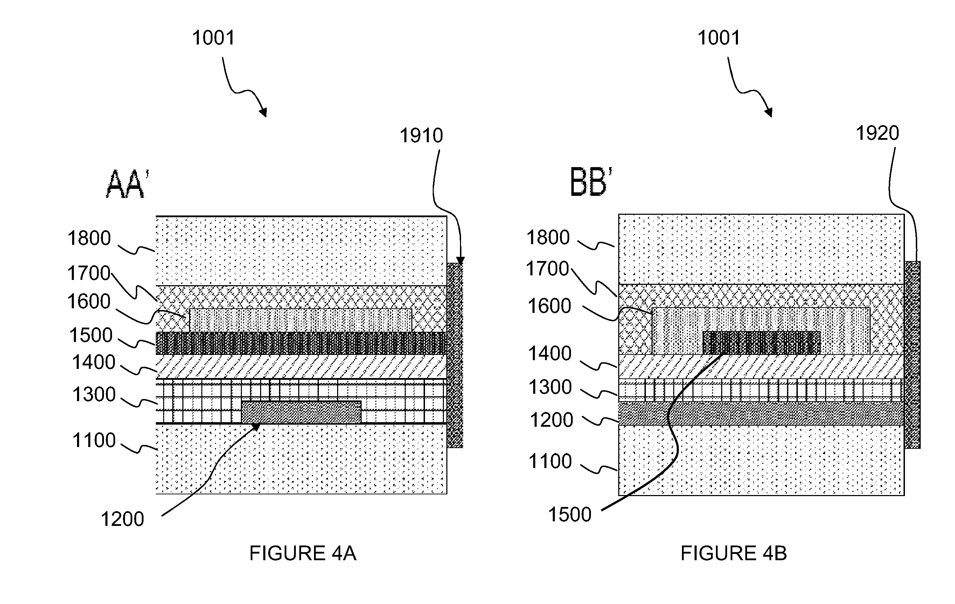

Reference is now made to **FIGURE 4A** and **4B****,** which schematically illustrates cross-sectional side view illustrations of OE die **1000** along line **A-A'** and **B-B',** respectively, together with a side-contact electrode, as outlined herein below in greater detail. An OE die comprising a side-contact electrode is hereinafter referred to as a "OE device". More specifically, an OED **1001** includes a first side-contact electrode **1910** that is provided sideways, i.e., on at least some part of the sidewall of OED **1001** such to make electrical contact with upper electrode material **1500** at least. First side-contact electrode **1910** may be deposited such to cover a first sidewall of OED **1001** entirely, or may be provided in a patterned manner such to correspondingly cover the first sidewall of OED **1001** only partially. Similarly, an electrical contact may be established between a second side-contact electrode **1920** and lower electrode material **1200** by providing second side-contact electrode **1920** on a second sidewall of OE die **1000,** wherein first sidewall and second sidewall may for example to a pair of sidewalls that are opposite to one another or to two a pair of sidewalls that are adjacent to one another at an angle of at least approximately 90 degrees. As a result thereof, lower electrode material **1200** and upper electrode material **1500** are indirectly electrically coupled with each other due to the voltage difference between first side-contact electrode **1910** and second side-contact electrode **1920.** More specifically, according to an embodiment of the invention, lower electrode material **1200** and upper electrode material **1500** are subjected to a voltage difference by first side-contact electrode **1910** and second side-contact electrode **1920,** respectively. The area wherein lower electrode material **1200** and upper electrode material **1500** are overlapping is the active area of OED **1001,** since upon applying a corresponding emission voltage, there is a flux of charges through said active area from lower electrode material **1200** to upper electrode material **1500,** or vice versa, depending on the direction of the voltage. As a result of the application of the emission voltage at lower electrode material **1200** and upper electrode material **1500,** light is emitted from OED **1001.** The operating voltage of an OED according to an embodiment of the invention may range, for example, from 4 to 6 Volts, or in some embodiments, be up to 230 V.

For bottom-emitting OEDs, substrate **1100** may be made of substantially transparent material such as, for example, glass, sapphire, plastic substrates (e.g., PE, PET, PEN, PP), or any other suitable material or combination of materials. The thickness of substrate **1100** may range, for example, from 100 µm to 2 mm.

In an embodiment wherein the structure of the OED is operative to be light emitting through the top or light-harvesting from the top, then substrate **1100** may be made of an opaque material. Correspondingly, cover **1800** is the preferably be made of a transparent material such as, for example, glass, sapphire, plastic substrates (e.g., PE, PET, PEN, PP), and the like.

Lower electrode material **1200** and/or upper electrode material **1500** are made of transparent or semi-transparent conductive material.

Whether lower electrode material **1200** and/or upper electrode material **1500** employed is transparent or semi-transparent depends on whether the OED is bottom-excited/emitting or top-excited/emitting. For bottom-excited/emitting electrodes, at least lower electrode material **1200** is (semi-)transparent and conductive, whereas for top-excited/emitting OEDs, upper electrode material **1500** is (semi-)transparent and conductive.

In an embodiment wherein the OED is bottom-emitting or bottom-excited, lower electrode material **1200** can be made of transparent oxides such as, for example, Indium-Tin-Oxide (ITO), Indium-Zinc-Oxide (IZO), Aluminum-Indium-Oxide (ATO), or any other suitable material. The thickness of lower electrode material **1200** may range for example, from 10 nm to 200 nm. Further, OEDs according to embodiments of the invention that are bottom-emitting or bottom-excited, or non-optical OEDs, upper electrode material **1500** may be made of electrode materials such as, for example, Al, Ni, Au, and the like.

Analogously, in an embodiment wherein the OED is top-emitting or top-excited, upper electrode material **1500** can be made of transparent oxides such as, for example, Indium-Tin-Oxide (ITO), Indium-Zinc-Oxide (IZO), Aluminum-Indium-Oxide (ATO), or any other suitable material, and the thickness of upper electrode material **1500** may range for example, from 10 nm to 200 nm. In OEDs according to embodiments of the invention that are of top-emitting or top-excited, or non-optical OEDs, lower electrode material **1200** may be made of electrode materials such as, for example, Al, Ni, Au, and the like.

In some embodiments, of the invention, lower electrode material **1200** and/or upper electrode material **1500** may be embodied by metal electrodes that are (semi-)transparent and conductive, for respective bottom- or top-emitting OEDs. The metal electrodes that may be employed have a thickness which is larger than the percolation threshold but still thin enough to possess an absorbance of, for example, ≤ 1 optical density (OD), ≤ 0.5 OD, or ≤ 0.25 OD.

As already briefly discussed hereinabove, an OED according to an embodiment of the invention includes at least one organic layer. Accordingly, OED **1001** exemplified herein as to include a plurality, or more specifically, two organic layers (lower organic layer **1300** and upper organic layer **1400**) shall not be construed as limiting. Therefore, an OED according to an embodiment of the invention may include a single layer of organic layer or, alternatively, at least three layers comprising at least organic layer and optionally inorganic layer, as outlined herein below in more detail. An OED embodying for example of polymer-based light-emitting diode (LED) may include a hole injection layer (e.g. Poly(3,4-ethylenedioxythiophene) or PEDOT) and a layer of a light-emitting polymer (LEP). The hole injection layer and/or the LEP may respectively have a thickness ranging, for example, from 200 nm down to 0.5 nm. Accordingly, the hole injection layer and/or the LEP layer may have a thickness of, for example, at least approximately 80 nm. Methods of depositing layers of organic or inorganic layer include, for example, at least one of the following: spin-coating, printing in general (e.g. via ink-jet, gravure, screen printing etc.), and vacuum coating (e.g. evaporation, plasma polymerization, sputtering, etc.).

In an embodiment of the invention, upper electrode material **1500** may be embodied by a stack of metal layers for carrier injection. In OEDs embodying, for example, OLEDs or OPDs, the metal layers may be made of low work function metals such as, for example, like, Ba, Ca, Li covered with an Ag or Al layer. Methods for providing upper electrode material **1500** may include, e.g., at least one of the following processes: ink-jet printing, gravure printing, and screen-printing or vacuum coating.

Employing getter material **1600** may extend the lifetime of an encapsulated OED Getter material **1600** may be made of, for example, barium, barium-oxide, calcium, calcium oxide, or any other material or combination of materials suitable to absorb impurities such as water and/or oxygen for example. Methods of providing getter material **1600** may include at least one of the following manufacturing processes: dispensing, printing, and other coating processes. The thickness of getter layer **1600** may range, for example, from 100 nm to a few micrometers such as 10 micrometers.

Glue **1700** may be embodied, for example, by at least one of the following materials: UV-curable, thermal-curable, and two-component epoxies. The thickness of glue **1700** may range, for example, between 1 to 80 micrometers.

Cover **1800** may be made of any suitable material such as, for example, glass, or plastic with sufficient barrier properties. Cover **1800** may have a thickness ranging, for example, from 25 µm to 1 mm.

First side-contact electrode **1910** and second side-contact electrode **1920** are made of materials suitable for establishing reliable contact with lower electrode **1200** and upper electrode **1500.** First side-contact electrode **1910** and/or second side-contact electrode **1920** may by provided e.g. by application (e.g., with a paint-brush) of conductive inks (e.g., silver ink); by evaporation of metals; or the sputtering of metals. Conductive inks can be applied e.g. by spraying or tampon-printing. The thickness of first side-contact electrode **1910** and/or second side-contact electrode **1920** embodied by conductive inks may, for example, range from 1 to 100 µm. The thickness of first side-contact electrode **1910** and/or second side-contact electrode **1920** embodied by sputtered or evaporated metals may range, for example, from 50 nm to 1 µm.

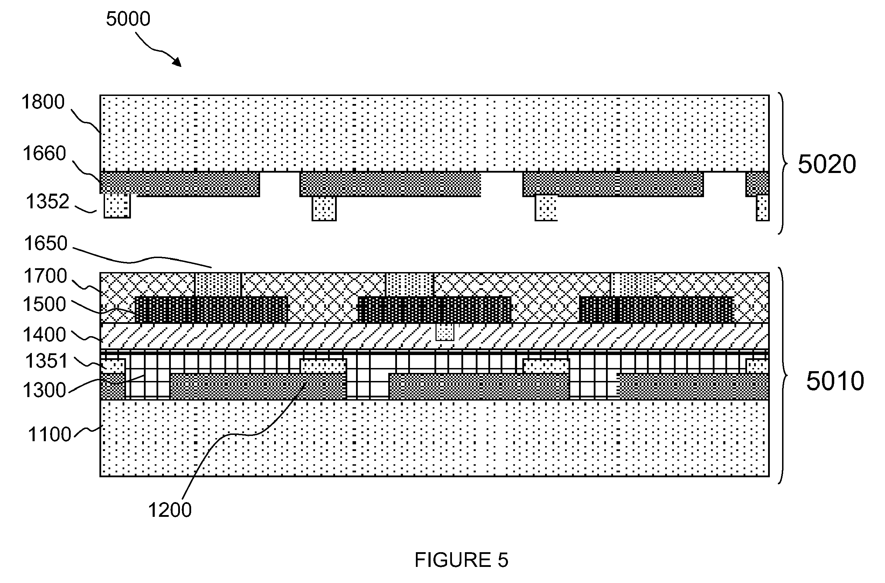

Additional reference is now made to **FIGURE 5****.** According to an embodiment of the invention, the method of manufacturing an OED comprises providing a sacrificial layer to obtain an OE die comprising an indentation at its sidewall increasing the contact area between a side-contact electrode and the sidewall of the OE die. More specifically, the side-contact electrodes engage with and fill said indentations. As a result of the increased contact area, the stability of the contact between the sidewall of the OE die and the side-contact electrode is increased, *inter alia,* due to increased friction between the OE die and the side-contact electrode.

It should be noted that the term "embedded" as used herein also encompasses the meaning "partially embedded". Accordingly, a sacrificial layer may in some embodiments be fully embedded by solid-state material, and in some embodiments, a sacrificial layer may be only be partially embedded by solid-state material such that some parts of the same sacrificial layer may be for example be in contact with ambient air during the process of manufacturing.

According to an embodiment of the invention, an OE stack **5000** for example, is manufactured such to additionally include a lower sacrificial layer **1351,** which may be provided, for example, in a manner such to be embedded between lower electrode material **1200** and lower organic layer **1300.** Additionally or alternative, an OE stack **5000** may be manufactured such to include an upper sacrificial layer **1352** which may, for example, be embedded between glue **1700** and a patterned conductive layer **1660.**

More specifically, lower sacrificial layer **1351** may be provided in a patterned manner directly on top of patterned lower electrode material **1200.** Lower organic layer **1300,** upper organic layer **1400** and upper electrode material **1500** may subsequently provided, e.g., as outlined hereinabove with respect to OE stack **1000.**

In an embodiment of the invention, the method may then additionally include the step of providing a conductive material **1650** onto upper electrode material **1500,** whereafter glue **1700** may be deposited.

According to an embodiment of the invention, on lower surface of cover **1800,** patterned conductive layer **1660** may be provided. Further, upper sacrificial layer **1352** may be provided on the lower surface of patterned conductive layer **1660.** Cover **1800,** patterned conductive layer **1660** and upper sacrificial layer **1352** are hereinafter referred to as "upper stack part" **5020.** The lower layers of OE stack **5000** are accordingly herein referred to as "lower stack part" **5010.**

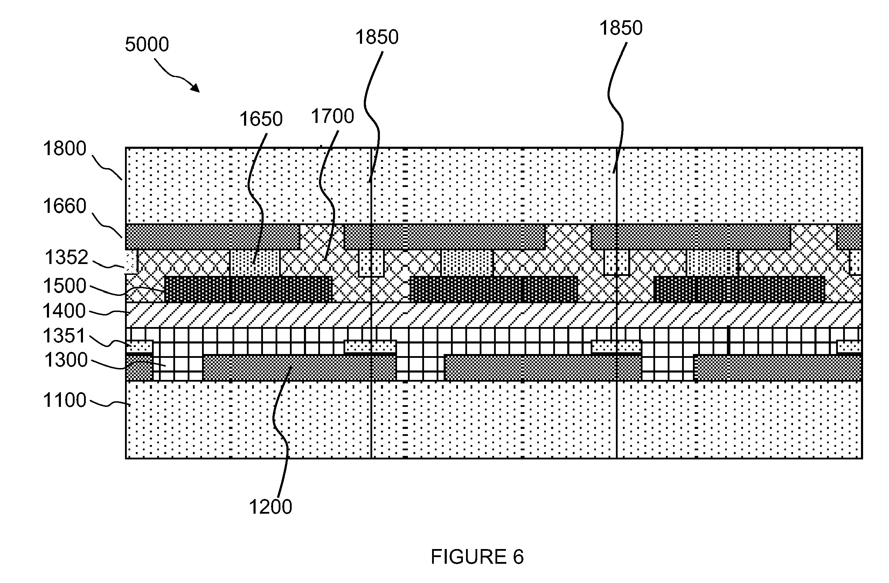

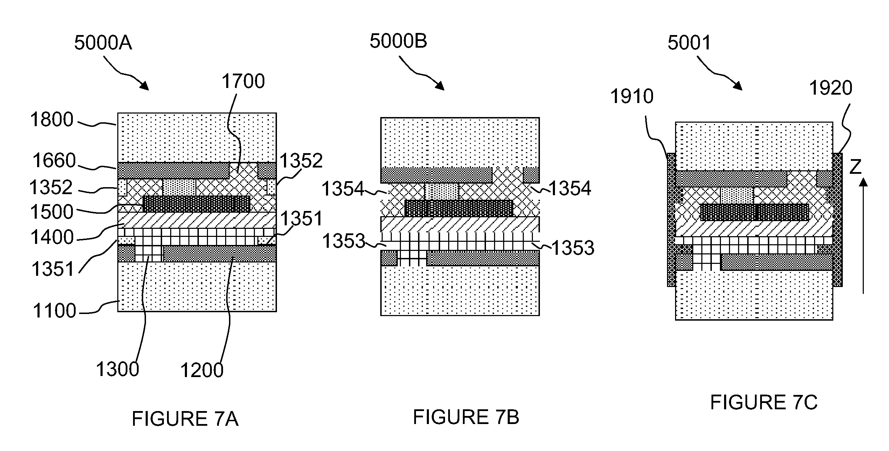

Additional reference is now made to **FIGURE 6****,** **7A, 7B** and **7C****.**

As outlined in greater detail below, an OED according to an embodiment of the invention may be devised such to include a horizontal electrode layer or layers extending to the left and right sidewalls of the OED. However, these horizontal electrode layer(s) are disconnected resulting in horizontal left electrode and right electrode portions which are electrically separated from one another. Otherwise side-contact electrodes contacts would directly short-circuit the different horizontal electrode layers. Such an electrode layer that comprises a left electrode portion and a right electrode portion are hereinafter referred to as "patterned lower/higher electrode material" or "patterned conductive layer".

The method of manufacturing an OE stack such as, for example, OE stack **5000** includes merging upper stack part **5020** with lower stack part **5010** such that conductive material **1650** and patterned conductive layer **1660** come into electrical contact and such that upper sacrificial layer **1352** is embedded by glue **1700** and patterned conductive layer **1660.** The resulting OE stack **5000** is then diced into individual OE dies **5000A (****FIGURE 7A****)** along cutting lines **1850** which run through lower sacrificial layers **1351** and upper sacrificial layer **1352.**

As schematically illustrated in **FIGURE 7B****,** lower sacrificial layer **1351** and upper sacrificial layer **1352** are then removed. The two sidewalls of the resulting OE die **5000B** may thus each comprise lower indentations **1353** and an upper indentations **1354.**

As is schematically illustrated in **FIGURE 7C****,** side-contact electrodes **1910** and **1920** are then deposited on the sidewalls such to at least partially cover the latter. More specifically, first side-contact electrode **1910** is provided on one side of OE die **5000B** such to fill both lower indentations **1353** and upper indentations **1354** and such to be at least in contact with patterned lower electrode material **1200** and upper electrode material **1500.** Analogously, second side-contact electrode **1920** is provided on the other side of OE die **5000B** such to fill both lower indentations **1353** and upper indentations **1354** and such to be at least in contact with patterned lower electrode material **1200** and upper electrode material **1500.** The increase in contact area between any of the electrode materials and the sidewalls of OE die **5000B** correspondingly increases the adhesiveness of the electrode materials with the sidewalls. Moreover, electrical contact with conductive layer **1660** may not only be made with the front face of conductive layer **1660,** but also with the lower surface of conductive layer **1660.** Analogously, electrical contact with patterned lower electrode material **1200** may not only be made with the front face of patterned lower electrode material **1200,** but also with the upper surface of patterned lower electrode material **1200.** As a consequence, a comparably more stable electrical contact can be made between conductive layer **1660** and wire bonds or side-contact electrodes, as well as a comparably more stable electrical contact can be made between patterned lower electrode material **1200** and wire bonds or side-contact electrodes.

According to an embodiment of the invention, lower sacrificial layer **1351** and upper sacrificial layer **1352** may be made of an (relatively easily) patternable material such as, for example, a photo-resist via lithography, removable and removed by appropriate solvents such as, for example, aceton, propanol, or the like. Clearly, glue **1700** needs to be resistant to these solvents in order to avoid removal of glue **1700** when subjecting OE die **5000B** to solvents.

According to an embodiment of the invention, conductive material **1650** may be embodied, for example, by metal paste (e.g., a silver paste) that is deformable such to enable electrical coupling of conductive material **1650** with patterned conductive layer **1660.** Patterned conductive layer **1660** may be made of, for example, ITO, Al, Ni, or any suitable electrically conductive material.

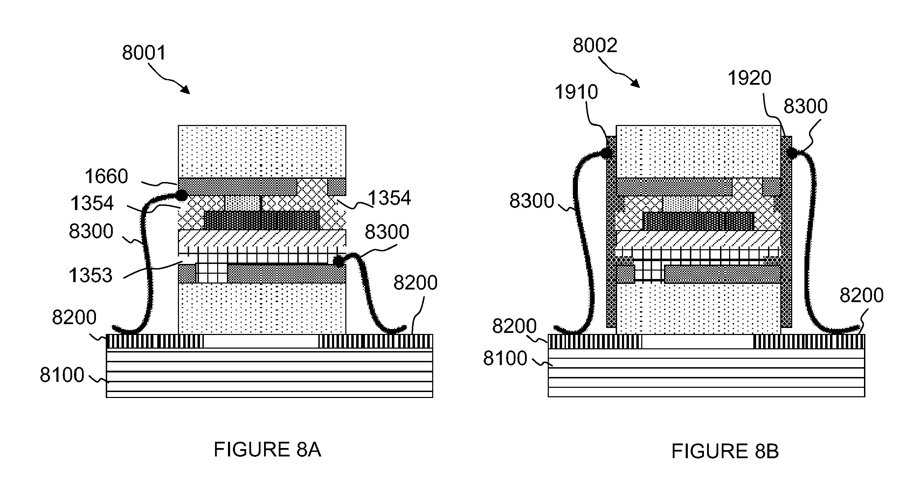

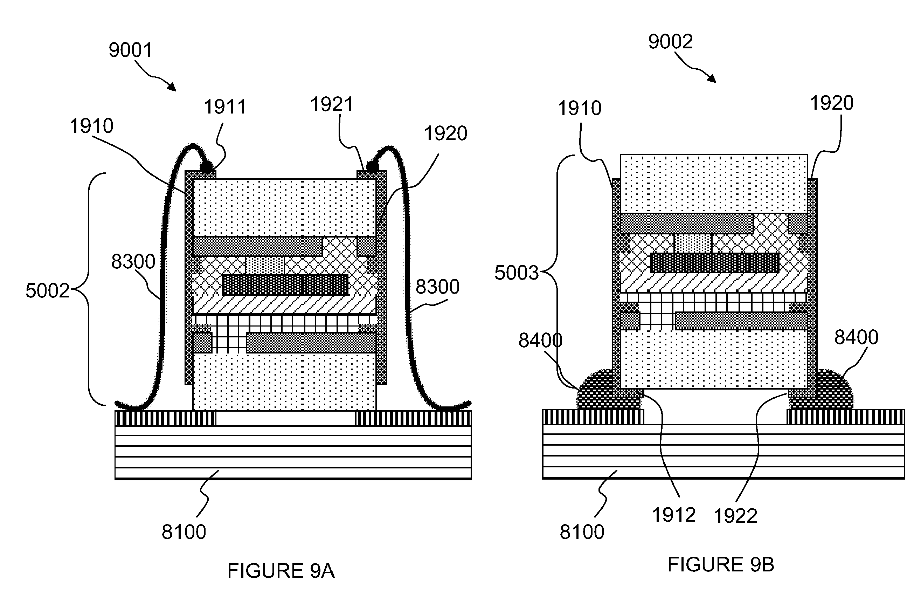

Further reference is now made to **FIGURE 8A, 8B****,** **9A** and **9B****.** An OE assembly **8001** according to an embodiment of the invention includes an OE die mounted and electrically coupled with conducting paths **8200** of a printed circuit board **8100.** Conducting paths **8200** are electrically coupled to external circuitry (not shown). Accordingly, the OE die is electrically coupled with the external circuitry.

As is for example schematically illustrated in **FIGURE 8A****,** an OE die such as, for example, OE die **5000B,** may be electrically coupled with conducting paths **8200,** for example, via wire bonds **8300** directly over patterned lower electrode material **1200** and patterned conductive layer **1660** of OE die **5001.**

Alternatively, as is for example schematically illustrated in **FIGURE 8B****,** an OE die such as, for example, OE die **5001,** first side-contact electrode **1910** and second side-contact electrode **1920** are electrically coupled with conducting paths **8200** via wire bonds **8300,** wherein the angle between the contact surface of conducting paths **8200** and the contact surface of side-contact electrodes **1910** and **1920** is at least approximately 90 degrees.

According to an alternative embodiment of the invention, as is schematically illustrated in **FIGURE 9A****,** in a OE die such as, for example, OE die **5002,** first side-contact electrode **1910** and/or second side-contact electrode **1920** may be provided onto OE die **5000B** such to extend from the at least approximately vertical sidewalls of OE die **5000B,** across its edges to the top of at least approximately horizontal upper surface of cover **1800,** and extend inwardly. First side-contact electrode **1910** and second side-contact electrode **1920** therefore comprises a first upper horizontal extension **1911** and a second upper horizontal extension **1921.** Thus, the contact area between side-contact electrodes **1910** and **1920** to the OE die is further increased. Correspondingly, first end of wire bonds **8300** may be electrically coupled with first horizontal upper extension **1911** and/or second horizontal upper extension **1921** of side-contact electrodes **1910** and/or **1920,** respectively. The corresponding second end of wire bonds 8300 are electrically coupled with conducting paths **8200.** As a result, OE die **5002** is electrically coupled with printed circuit board **8100** to form an OE assembly **9001.**

Additional reference is now made to **FIGURE 9B****.** In some embodiments of the invention an OE assembly such as, for example, OE assembly **9002,** may include an OE die such as, for example, OE die **5003,** which may include side-contact electrodes **1910** and **1920** each extending over the lower opposite edges of OE die **5003** from the at least approximately vertical and opposite sidewalls of OE die **5003** horizontally and inwardly along the lower surface of substrate **1100.** First side-contact electrode **1910** and second side-contact electrode may thus have a first lower horizontal extension **1912** and a second lower horizontal extension **1922.** Thus, the contact area between side-contact electrode **1910** and **1920** to the OE die is further increased. OE die **5003** may be electrically coupled with conductive paths **8200** via conductive connections **8400.** Conductive connections **8400** may be provided before or after positioning OE die **5003** on printed circuit board **8100.** Conductive connections **8400** may for example be made of Ag-ink, Ag-paste or a solder paste, e.g., as used in the art in a standard reflow soldering process.

The following, a method of manufacturing an OE stack is exemplified. For example, a substrate **1100** made, e.g., glass and having the size of e.g., the size 2"x2" and of, e.g., 0.7 mm thickness, may be coated with patterned lower electrode material **1200** made, of, e.g., ITO, with a thickness of, e.g., 150 nm. Patterned lower electrode material **1200** may then be patterned by employing, e.g., photolithography and wetetching, into at least approximately parallel strips having a width of, e.g., 2 mm and a grid period of, e.g., 4 mm. Substrate **1100** may then for example be plasma treated in a vacuum reactor. Lower organic layer **1300** of, e.g., a polymer (PEDOT, AL4083 from H.C.Starck) may then be deposited on substrate **1100,** e.g., via spin-coating and dried on a hot plate at a temperature of for example 200°C for, e.g., 10 minutes which may result in a layer thickness of the organic layer of about 70 nm for example. Upper organic layer **1400** made, for example, of light-emitting polymer (e.g. PDY132 form Merck) may then be deposited by employing, e.g., spin-coating (at a speed of, e.g.,1500 rpm) and baked on a hotplate at a temperature of ,e.g., 80 °C, for, e.g., 10 minutes which results in a thickness of for example, about 70 nm. Upper electrode material **1500** made of a bilayer for example Barium (having a thickness of, e.g., 5 nm) and Aluminum with a thickness of e.g., 70 nm may then be successively evaporated on top of lower organic layer **1300** through a shadow mask to create at least approximately parallel patterned strips of upper electrode material **1500.** These strips of upper electrode material **1500** may for example have a width of, e.g., 2 mm and grid period of, e.g., 4 mm. The strips of upper electrode material **1500** may be patterned such to be perpendicular to the strips of patterned lower electrode material **1200.** The stack below and including upper electrode material **1500** is hereinafter referred to as "organic stack".

Under inert-gas (e.g., N2) glovebox, glue **1700** made, of, e.g., an UV-curable epoxy (e.g. DELO LP651) may then be deposited on top of a cover **1800** made of, e.g., glass having a size of, e.g., size 2"x2". This cover glass is placed with the glue-side on top of the organic stack. Glue **1700** may then be cured via intense UV-light, to obtain an OE stack. The obtained OE stack having dimensions of e.g., 2"x2", is diced into OE dies, each die having dimension of, e.g., 4 mm x 4 mm. The OE dies are then provided with first side-contact electrode **1910** and second side-contact electrode **1920** which may be embodied, for example, by conductive silver ink (e.g. Ferro GmbH), e.g., with a paintbrush. The OED is thus actually finalized. For further encapsulation of the active material, the edges of the OE dies can be additionally covered with a special barrier layer which may for example be made of SiOₓ, SiNₓ, parylene or organic-inorganic multilayers.

It will be appreciated by persons skilled in the art that the disclosed invention is not limited to what has been particularly shown and described hereinabove.

## Claims

1. A method for manufacturing an Organic-Electronic Device (OED), said method comprising:
a) providing at least one lower electrode onto a substrate;
b) providing at least one lower organic layer onto said lower electrode;
c) providing at least one upper electrode onto said lower organic layer to obtain an OE stack;
d) dicing said OE stack into a plurality of OE dies;
**characterized in that** said method further comprises:
providing a plurality of side-contact electrodes on at least one sidewall of at least one of said plurality of OE dies,
wherein at least one first of said plurality of side-contact electrodes is electrically coupled with said at least one first lower electrode;
wherein at least one second of said plurality of side-contact electrodes is electrically coupled with said at least one second lower electrode; and
wherein a plurality of voltages are respectively applicable to said plurality of side-contact electrodes such that said at least one lower and at least one upper electrode become electrically connected over said at least one lower organic layer.

2. The method for manufacturing the OED according to claim 1, said method further comprising:
a) providing a glue onto said upper electrode; and
b) providing a cover onto said upper electrode to obtain an OE stack.

3. The method for manufacturing the OED according to claim 1 or 2, said method comprising:
providing a sacrificial layer prior to dicing said OE stack; and
removing said sacrificial layer after dicing said OE stack into OE dies to obtain indentations, wherein said indentations increase the area of the sidewalls of said OE dies; and
providing said lower and said upper electrodes on said sidewalls with said increased contact area.

4. The method for manufacturing the OED according to any of the preceding claims, said method comprising providing a getter material onto said upper electrode material, said getter material absorbing impurities.

5. A Organic Electronic Device (OED) comprising:
a substrate;
at least one lower electrode on said substrate;
at least one organic layer, wherein said at least one lower electrode is embedded between said substrate and said at least one organic layer;
at least one upper electrode provided on said lower organic layer;
**characterized in that** said OED further comprises:
a plurality of side-contact electrodes,
wherein said plurality of side-contact electrodes electrodes are provided on at least one sidewall of said OED.

6. A Organic Electronic Device (OED) according to claim 5
wherein said first side-contact electrode and said second side-contact electrodes are provided on a first and a second sidewall of said OED,
wherein said first and said second sidewall of said OED have one of the following orientations with respect to each other:
said first sidewall is opposite to said second sidewall, or
said first sidewall is adjacent and to said second sidewall and form an angle of at least approximately 90 degrees.

7. The OED according to claim 5 or 6, wherein said plurality of side-contact electrodes has a thickness of ≤ 1 micrometer.

8. The OED according to any of the claims 5 to 7, wherein the electrical contact area between said plurality of side-contact electrodes and said lower electrode material, as well as the electrical contact area between said plurality of side-contact electrodes and said upper electrode material, is the cross-sectional area of the strips of said lower and upper electrode material.

9. A Organic Electronic (OE) Assembly comprising:
a substrate;
at least one lower electrode on said substrate;
at least one organic layer, wherein said at least one lower electrode is embedded between said substrate and said at least one organic layer;
at least one upper electrode provided on said lower organic layer;
**characterized in that** said OED further comprises:
a plurality of side-contact electrodes which are provided on at least one sidewall of said OED;
a printed circuit board comprising conductive paths; and
wherein said OED is electrically coupled with said printed circuit board via said plurality of side-contact electrodes.
